Europäisches Patentamt

European Patent Office

Office européen des brevets

(11) Veröffentlichungsnummer: **0 390 254**
**A2**

## EUROPÄISCHE PATENTANMELDUNG

(21) Anmeldenummer: 90200654.3

(22) Anmeldetag: 20.03.90

(51) Int. Cl.⁵: **G05D 21/00**

(30) Priorität: 25.03.89 DE 3909915

(43) Veröffentlichungstag der Anmeldung:
**03.10.90 Patentblatt 90/40**

(84) Benannte Vertragsstaaten:
**DE FR GB IT NL**

(71) Anmelder: **N.V. Philips' Gloeilampenfabrieken**
**Groenewoudseweg 1**
**NL-5621 BA Eindhoven(NL)**

(72) Erfinder: **van den Meerakker, Johannes**
**Engelbertus A. M.**
**Groenewoudseweg 1**
**NL-5621 BA Eindhoven(NL)**

(74) Vertreter: **David, Günther M. et al**
**Philips Patentverwaltung GmbH**
**Wendenstrasse 35 Postfach 10 51 49**
**D-2000 Hamburg 1(DE)**

(54) Verfahren zum Stabilisieren von Reinigungsbädern für Si-Scheiben, insbesondere für Halbleiterbauelemente.

(57) Die Erfindung betrifft ein Verfahren zum Stabilisieren von alkalischen, Wasserstoffperoxid ($H_2O_2$) enthaltenden Reinigungsbädern für Si-Scheiben, insbesondere für Halbleiterbauelemente, bei dem auf einfache Weise sichergestellt wird, daß die $H_2O_2$-Konzentration des Bades auf Werte absinkt, bei denen die Si-Scheiben angeätzt werden.

Dies wird dadurch erreicht, daß in dem Bad das Potential einer Si-Scheibe gegenüber einer Bezugselektrode (Kalomelelektrode) gemessen und die $H_2O_2$-Konzentration im Bad wieder erhöht wird, wenn sich das Potential stark zu negativeren Werten verschiebt.

FIG.2

EP 0 390 254 A2

## Verfahren zum Stabilisieren von Reinigungsbädern für Si-Scheiben, insbesondere für Halbleiterbauelemente

Die Erfindung betrifft ein Verfahren zum Stabilisieren von alkalischen, Wasserstoffperoxid ($H_2O_2$) enthaltenden Reinigungsbädern für Si-Scheiben.

Reinigungsbäder dieser Art sind z.B. aus "Semiconductor International" (April 1984, 94 bis 99) bekannt. In solchen Reinigungsbädern werden insbesondere organische Verunreinigungen und metallische Kontaminationen von der Oberfläche der Si-Scheiben entfernt, ohne daß die Scheiben angeätzt werden, so lange die $H_2O_2$-Konzentration im Bad nicht zu niedrig wird.

Es ist bereits bekannt (siehe Patent Abstracts of Japan, Section E 109, Seite 140 (Kokai 54-33 673)) in einem solchen Bad die $H_2O_2$-Konzentration colorometrisch (mit Hilfe von ultraviolettem Licht) zu bestimmen.
Ein solches Verfahren ist technisch aufwendig. Zudem hängt die $H_2O_2$-Konzentration, die nicht unterschritten werden darf, damit die Si-Scheiben nicht angeätzt werden, auch vom pH-Wert des Bades, seiner Temperatur und der Kristallorientierung und der Dotierung der Si-Scheiben ab. Alle diese Werte müssen mit berücksichtigt werden, um sicherzustellen, daß bei einer gemessenen $H_2O_2$-Konzentration die Si-Scheiben nicht angeätzt werden.

Der Erfindung liegt nun die Aufgabe zugrunde, ein Verfahren der eingangs genannten Art so auszugestalten, daß auf einfache, technisch wenig aufwendige Weise sichergestellt werden kann, daß das Reinigungsbad die Si-Scheiben nicht anätzt.

Diese Aufgabe wird dadurch gelöst, daß in dem Bad das Potential einer Si-Scheibe gegenüber einer Bezugselektrode gemessen und die $H_2O_2$-Konzentration im Bad wieder erhöht wird, wenn sich das Potential stark zu negativeren Werten verschiebt.
Die Erfindung geht dabei von der Erkenntnis aus, daß sich in dem Bad auf den Si-Scheiben eine ein Anätzen verhindernde Oxidschicht bildet, die aber verschwindet, wenn die $H_2O_2$-Konzentration im Bad einen bestimmten Wert unterschreitet.

Die mit der Erfindung erzielten Vorteile sind insbesondere darin zu sehen, daß durch eine einfache, kontinuierliche oder periodische Potentialmessung und Erhöhen der $H_2O_2$-Konzentration, wenn das gemessene Potential stark absinkt, das Reinigungsbad stabil gehalten, ein Anätzen der Scheiben also vermieden werden kann.

Weitere Ausgestaltungen der Erfindung ergeben sich aus den Unteransprüchen.

Vorzugsweise wird die $H_2O_2$-Konzentration dann erhöht wenn sich das gemessene Potential um mindestens 400 mV pro 30 s ändert.
Das Reinigungsbad besteht vorzugsweise aus $H_2O$,

$NH_4OH$ (25 %) und $H_2O_2$ (30 %) in einem Volumenverhältnis von etwa 5:1:1. Der pH-Wert liegt zwischen 10 und 14 und die Badtemperatur ist höher als 40 °C. Als Bezugselektrode wird vorzugsweise eine Kalomelelektrode oder bei einem stark alkalischen Bad eine Hg/HgO-Elektrode verwendet.

Ausführungsbeispiele der Erfindung werden im folgenden anhand der beigefügten Zeichnung näher erläutert.
Es zeigen:
Fig. 1 ein Reinigungsbad mit Si-Scheiben und einer Bezugselektrode,
Fig. 2 den zeitlichen Verlauf des Potentials einer Si-Scheibe gegenüber der Bezugselektrode während des Reinigungsvorganges.

Die Figur zeigt ein Reinigungsbad 1, in das in einem Träger 11 Si-Scheiben 3 in die Reinigungsflüssigkeit 2 eingesetzt sind.
Die Reinigungsflüssigkeit besteht aus 50 Volumenteilen Wasser, 10 Volumenteilen $NH_4OH$ (25%) und 10 Volumenteilen $H_2O_2$ (30%). Ihr pH-Wert beträgt etwa 11.
Von einer der eingesetzten Si-Scheiben wird mit Hilfe eines Instruments 6 das Potential gegenüber einer gesättigten Kalomelelektrode 5 gemessen. Diese Si-Scheibe 3a ist zu diesem Zweck an einer Hauptfläche mit einer Kontaktelektrode aus Aluminium versehen. Wenn das gemessene Potential eine Erhöhung der $H_2O_2$-Konzentration erforderlich macht, wird über eine Wirkverbindung 7 ein Ventil 8 geöffnet, so daß eine bestimmte Menge $H_2O_2$ aus einem Vorratsbehälter 9 in die Reinigungsflüssigkeit eintritt. Dies geschieht bei dem beschriebenen Bad bei einer Temperatur von 70 °C etwa 2 1/2 h nach dem Mischen der Bestandteile des Bades. Das Potential sinkt dabei von etwa -400 mV auf -800 mV und steigt nach dem Beimischen von $H_2O_2$ wieder auf -400 mV.

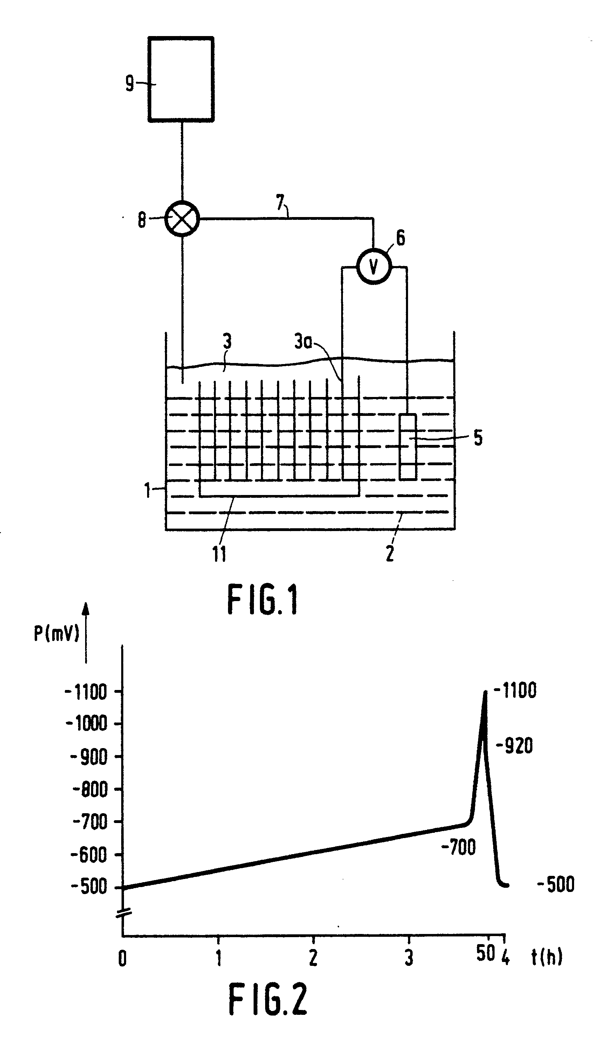

In einem weiteren Ausführungsbeispiel werden mit der in Figur 1 dargestellten Einrichtung Si-Scheiben vom p-Typ in einem Bad gereinigt, das aus Wasser und 0,05 molar $H_2O_2$ besteht. Es ist mit Phosphat auf einen pH-Wert von 12 gepuffert. Die Badtemperatur beträgt ebenfalls 70 °C.

Der Verlauf des an einer Si-Scheibe 3a gegenüber der Kalomel-Bezugselektrode 5 gemessenen Potentials ist in Figur 2 dargestellt.
Nach dem Einsetzen der Si-Scheiben in das Reinigungsbad beträgt das Potential -500 mV und sinkt dann über 3 h, 50 m auf einen Wert von etwa -700 mV. Dann sinkt das Potential binnen 30 s auf einen Wert von -1100 mV und ein Ätzen der Si-Scheiben setzt ein. Während des Ätzens wird ein Potential von -920 mV gemssen. Durch das unverzügliche Erhöhen der $H_2O_2$-Konzentration wird dies wieder unterbunden und das Potential steigt wieder auf -500 mV.

Das erfindungsgemäße Verfahren ist nicht nur in Verbindung mit Si-Scheiben anwendbar sondern auch beim Reinigen von anderen Halbleitern oder Metallen in Bädern der eingangs genannten Art, bei dem durch $H_2O_2$ eine das Ätzen verhindernde Oxidschicht abgebaut wird.

## Ansprüche

1. Verfahren zum Stabilisieren von alkalischen, Wasserstoffperoxid ($H_2O_2$) enthaltenden Reinigungsbädern für Si-Scheiben, insbesondere für Halbleiterbauelemente,
dadurch gekennzeichnet,
daß in dem Bad das Potential einer Si-Scheibe gegenüber einer Bezugselektrode gemessen und die $H_2O_2$-Konzentration im Bad wieder erhöht wird, wenn sich das Potential stark zu negativeren Werten verschiebt.

2. Verfahren nach Anspruch 1,
dadurch gekennzeichnet,
daß die $H_2O_2$-Konzentration erhöht wird wenn sich das gemessene Potential um mindestens 400 mV pro 30 s zu negativeren Werten ändert.

3. Verfahren nach Anspruch 1 oder 2,
dadurch gekennzeichnet,
daß ein $H_2O$, $NH_4OH$ (25 %) und $H_2O_2$ (30 %) in einem Volumenverhältnis von etwa 5:1:1 enthaltendes Reinigungsbad verwendet wird.

4. Verfahren nach einem der vorangehenden Ansprüche,
dadurch gekennzeichnet,
daß der pH-Wert des Reinigungsbades auf einen Wert zwischen 10 und 14, vorzugsweise 11, eingestellt ist.

5. Verfahren nach einem der vorangehenden Ansprüche,
dadurch gekennzeihnet,
daß als Bezugselektrode eine gesättigte Kalomelelektrode verwendet wird.

EP 0 390 254 A2

FIG.1

FIG.2